(19) Europäisches Patentamt
European Patent Office
Office européen des brevets

(11) Publication number: **0 408 334 A2**

# (12) EUROPEAN PATENT APPLICATION

(21) Application number: **90307573.7**

(51) Int. Cl.$^5$: **G03F 7/075**

(22) Date of filing: **11.07.90**

(30) Priority: **14.07.89 JP 180587/89**

(43) Date of publication of application:
**16.01.91 Bulletin 91/03**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Motoyama, Takushi**
**159, Shimokodanaka, Nakahara-ku**
**Kawasaki-shi, Kanagawa 211(JP)**

(74) Representative: **Overbury, Richard Douglas et al**
**Haseltine Lake & Co Hazlitt House 28,**
**Southampton Buildings Chancery Laneane**
**London WC2A 1AT(GB)**

## (54) Silicon-containing resists and microlithography using same.

(57) A resist comprising of a mixture of either poly 4,4,6,6-tetramethyl-4,6-disila-heptyne or poly 4,4,7,7-tetramethyl-4,7-disila-2-octyne as a host polymer and an additional reagent having at least a radical reactive on the double bond of the host polymer, and a patterning process using this resist, particularly as a top patterning resist in a bilayer system.

EP 0 408 334 A2

# SILICON-CONTAINING RESISTS AND MICROLITHOGRAPHY USING SAME

The present invention relates to silicon-containing resists, particularly useful when applied as a top patterning resist of a bilayer system, and to a microlithography process using such resists.

As the technology of preparing integrated circuits in microelectronics demands a fine patterning for lithography, it becomes even more necessary for such resists to exhibit a high sensitivity and resolution.

Resists, particularly top patterning resists, are usually exposed to a 248 nm KrF excimer laser beam, to obtain a fine resolution, and thus the resists must have a high sensitivity to such an ultraviolet beam.

It is known that dry development is advantageous, because resists can be developed without swelling, and thus a fine resolution can be obtained. A selective dry development is effected by a dry removal of resists in exposed or unexposed regions. For example, in the case of negative resists, the unexposed regions are removed.

A dry development is usually carried out by subjecting the resists to an oxygen plasma accompanied by an ionic bombardment, whereby the oxygen plasma reduces the remaining thickness of the resist. The term "remaining thickness" in negative development is defined as the ratio of a remaining thickness of the exposed resist determined after removing the unexposed regions to the thickness of the resist determined before the development.

In a bilayer system, a bottom resist is thick enough to flatten the uneven surface of a multilayer circuit board, and a top patterning resist covers the bottom resist. First, the top patterning resist is exposed to an excimer laser beam and developed to form upper patterns, and thereafter, this resist serves as a mask for an anisotropic etching of the bottom resist. Therefore, a resist adapted for use as a top patterning resist in a bilayer system must exhibit a high resistivity to oxygen reactive ion etching or oxygen electron cyclotron etching, in addition to the fundamental characteristics of resists, i.e., a high sensitivity, resolution, and remaining thickness.

It is known that silicon-containing resists exhibit a high resistivity to oxygen reactive etching, and such resists are usually a mixture composed of a host polymer and an additional reagent. The useful host polymers are polyacetylene having an unsaturated bond in the main chain and at least a silicon atom in each side chain of one repeating unit. The additional reagent has at least a radical reactive on the unsaturated bond of the host polymer.

Japanese Unexamined Patent Publication No. 1-23484 assigned to Fujitsu Ltd. which corresponds to European Patent Publication A-0333591 discloses a resist in which poly 1-(trimethyl silyl) propyne as a host polymer is mixed with 2,6-bis (4′-diazide benzal)cyclohexanone as an additional reagent. Nevertheless, the dry development characteristics are not satisfactory, the sensitivity is 70 mJ/cm$^2$ at a 75% remaining thickness, the resolution is 0.7 $\mu$m, and the resistivity to reactive ion etching is not satisfactory for use as a top patterning resist in a bilayer system.

This Japanese Unexamined Patent Publication discloses another example of a resist, in which poly[1,2-bis(trimethyl silyl) acetylene as a host polymer and cinnamoyl chloride as an additional reagent are mixed. The sensitivity is 120 mJ/cm$^2$ at a 90% remaining thickness and the resolution is 0.5 $\mu$m.

Accordingly, the present invention seeks to provide resists which exhibit a high sensitivity, resolution, remaining thickness, and resistivity to reactive ion etching or electron cyclotron resonance plasma etching.

The present invention also seeks to provide a process for forming negative patterns using such resists.

The present invention further seeks to provide a process for patterning resists in a bilayer system by using such resists as top patterning resists.

Other objects and advantages of the present invention will become further apparent from the following description of the present invention with reference to the attached drawings.

According to one aspect of the present invention, there is provided a resist characterized by being composed of a mixture of either poly 4,4,6,6-tetramethyl-4,6-disila-2-heptyne (PTMDSH) or poly 4,4,7,7-tetramethyl-4,7-disila-2-octyne (PTMDSO) as a host polymer, and an additional reagent having a radical reactive on the double bond of the host polymer.

According to another aspect of the present invention, there is provided a process for a formation of resist patterns characterized by comprising the steps of:

coating a resist material onto a substrate to form a resist layer, said resist material comprising a mixture of either poly 4,4,6,6-tetramethyl-4,6-disila-2-heptyne or poly 4,4,7,7-tetramethyl-4,7-disila-2-octyne as a host polymer, and an additional reagent having at least a radical reactive on the double bond of said host polymer;

exposing said resist layer by patterning radiation; and

developing said resist layer, to thereby remove unexposed areas of said resist layer on the substrate.

Preferably, the additional reagent is a diazide aromatic compound, and the additional reagent may be selected from the group consisting of 3,3′-diazide diphenyl methane (3DADPMe), 4,4′-diazide diphenyl methane(4DADPMe), 4,4,-diazide diphenyl ethane (4DADPEt) and 4,4′-diazide diphenyl ether (4DADPEr).

Preferably the resist is exposed to ultraviolet beams, and then baked in a vacuum, to thereby remove unreacted additional reagent.

Also preferably the exposed resist is developed by a downstream of the plasma of a mixture of oxygen and a carbon fluoride or a hydrocarbon fluoride.

Figure 1 is a schematic diagram of a downstream development process;

Fig. 2 shows a schematic illustration of a downstream plasma development apparatus;

Fig. 3 shows the dependence of the remaining thickness of a mixture of PTMDSO and 3DADPMe on exposure energy density;

Fig. 4 shows the dependence of the remaining thickness of a mixture of PTMDSO and 3DADPMe on pressure; and

Fig. 5 shows the dependence of a $O_2/CF_4$ plasma downstream etching rate of a mixture of PTMDSO and 3DADPMe on pressure.

The present invention will be described in detail with reference to the drawings.

The host polymer of the resist according to the present invention is either poly 4,4,6,6-tetramethyl-4,6-disila-2-heptyne (PTMDSH) as shown in formula (1):

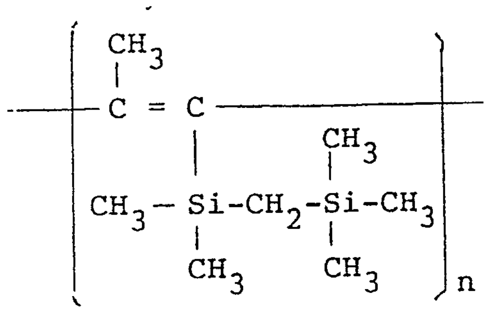

(1)

or poly 4,4,7,7-tetramethyl-4,7-disila-2-octyne (PTMDSO), as shown in formula (2):

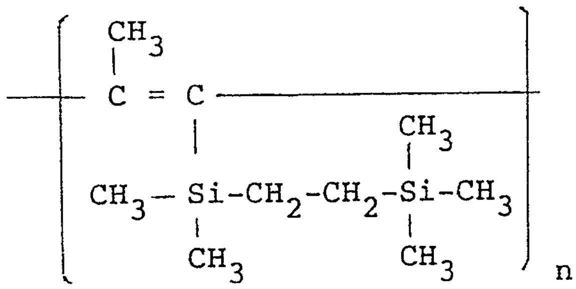

(2)

Among the diazide aromatic compounds for use as the additional reagents the following compounds are included. Note, these compounds in no way limit the present invention.

3,3'-diazide diphenyl methane (3DADPMe)

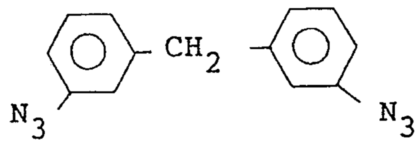

(3)

4,4'diazide diphenyl methane (4DADPMe)

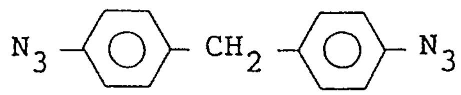

(4)

4,4'-diazide diphenyl ethane (4DADPEt)

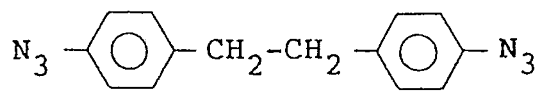

(5)

4,4'-diazide diphenyl ether (4DADPEr)

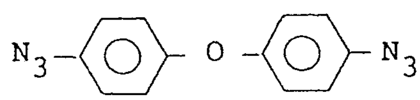

(6)

The dry development of the resist according to the present invention is schematically illustrated in Fig. 1, in which P denotes a host polymer and A denotes an additional reagent.

In step 1, the resist is exposed to an ultraviolet beam, and the additional reagent generates a radical as shown in the following formula:

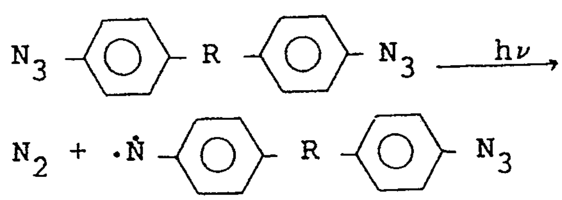


Then, the excited radical is combined with the double bond of the main chain of the repeating unit of the host polymer, as follows:

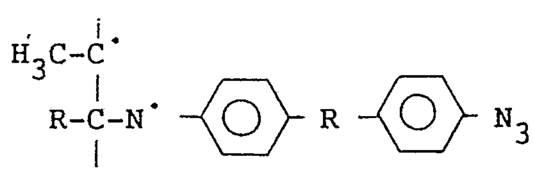

and the remaining azide group also generates an excited radical during exposure to an ultraviolet beam, and this radical is similarly combined with another double bond of the host polymer. Furthermore, the remaining radicals are excited and continue to provide similar combinations. Accordingly, aromatic rings are introduced into the host polymer and the number of double bonds of the host polymer is reduced in the exposed region, whereby the resistivity thereof as a mask for an anisotropic etching of the bottom resist is increased.

In step (2), the resist is baked in a vacuum, and the unreacted additional reagent is thereby vaporized and removed.

In step (3), the resist is subjected to the downstream flow of $O_2/CF_4$ plasma and the unreacted host

polymer in the unexposed region is removed, without damage to the exposed resist, because the oxygen ion bombardment is blocked by a shield located between a plasma generating chamber and a development chamber, and thus a dry development of the resist is accomplished.

Figure 2 is a schematic illustration of a downstream development apparatus.

A wafer 1, having resist applied to the surface thereof, is placed in a dry development chamber 2, and a gas mixture of $O_2/CF_4$ is introduced into a plasma generating chamber 3 connected to a magnetron 4. Then $O_2/CF_4$ plasma 5 is generated and stays above a microwave shielding plate. Only neutral species containing fluorine and oxygen radicals pass through the holes of the shielding plate and attack the resist on the wafer 1.

Example 1

(1) Novolak resist (Tokyo Oka Kogyo K.K. OFPR-800) was spun-coated on a wafer and baked at 200° C, to thereby form a bottom resist layer having a thickness of 1.7 µm.

(2) Poly4,4,6,6-tetramethyl-4,6-disila-2-heptyne (PTMDSH) was synthesized from the monomer thereof, 4,4,6,6-tetramethyl-4,6-disila-2-heptyne (Shinetsu Kagaku Kogyo, K.K.), using tantalum pentachloride as a catalyzer, and 3,3′-diazide diphenyl methane (3DADPMe) was synthesized by the conventional method.

Then, PTMDSH and 3DADHMe were dissolved in a weight ratio of 2:1 in xylene to form a solution of 2% by weight thereof, and the solution was spun-coated on the bottom resist layer and dried to form a top resist layer having a thickness of 0.45 µm.

(3) The wafer was exposed to a KrF excimer laser beam using a reduction stepper system (step 1 of Fig. 1).

(4) The exposed wafer was baked at 70° C under a reduced pressure of about 0.01 Torr for 5 minutes, and the unreacted 3DADPMe was removed (step 2 of Fig. 1).

(5) The wafer was subjected to the plasma downstream using an apparatus as shown in Fig. 2, under the following conditions:

| | |
|---|---|
| oxygen | 1000 SCCM |
| carbon tetrafluoride | 500 SCCM |
| pressure | 6 Torr |
| power | 900 W |

Thus, the top patterning resist was dry developed (step 3 of Fig. 1).

The obtained negative pattern exhibited a line and space resolution of about 0.35 µm, and a sensitivity of 80 $mJ/cm^2$ at a remaining thickness of 90%. Figure 3 shows the obtained dependence of the remaining thickness on the exposure energy density. Referring to Fig. 3, this value of sensitivity is converted to 50 $mJ/cm^2$ at a remaining thickness of 75%, and thus the resolution and sensitivity are superior to those obtained in the Examples of the Japanese Patent Publication set forth above.

(6) The bottom resist layer was then patterned by electron cyclotron plasma etching under the following conditions:

| | |
|---|---|
| oxygen | 110 SCCM |
| pressure | $3 \times 10^{-3}$ Torr |
| power | 1 kW |
| RE bias power | 200 kHz, 60 W |

Example 2

The experiment of Example 1 was repeated except that poly 4,4,7,7-tetramethyl-4,7-disila-2-octyne (PTMDSO) was prepared in the same way as PTMDSH and used as the host polymer of the top patterning resist instead of PTMDSH. The sensitivity of the top patterning resist was determined to be 80 $mJ/cm^2$ at a

remaining thickness of 90%. In the following examples, the remaining thickness at which sensitivity was determined was 90%, similar to that of Example 1.

Example 3

The experiment of Example 1 was repeated except that 4,4′-diazide diphenyl methane (4DADPMe) was used as the additional reagent. The sensitivity of the top patterning resist was 100 $mJ/cm^2$.

Example 4

The experiment of Example 3 was repeated except that PTMDSO was used as the host polymer.

The sensitivity of the top patterning resist was 110 $mJ/cm^2$.

Example 5

The experiment of Example 1 was repeated except that PTMDSO was used as the host polymer, and the additional reagent was 4,4 -diazide diphenyl ethane. The top patterning resist was exposed by a contact mask aligner system, and the sensitivity of the top patterning resist was 110 $mJ/cm^2$.

Example 6

The experiment of Example 5 was repeated except that 4,4 -diazide diphenyl ether was used as the additional reagent. The sensitivity of the top patterning resist was 90 $mJ/cm^2$.

Example 7

The top patterning resist layer was coated on a wafer, exposed, and baked in the same way as in Example 2, except that the baked resist was subjected to the $O_2/CF_4$ plasma downstream under the following conditions:

| | |
|---|---|
| oxygen | 1000 SCCM |
| carbon tetrafluoride | 500 SCCM |
| power | 950 W |
| pressure | 1 to 6 Torr |

Figure 4 shows the dependence of the remaining thickness of a mixture of PTMDSO and 3DADPMe on pressure. It can be seen from the curve that the remaining thickness increases as the pressure increases, and that more than 90% of the remaining thickness was obtained above 3 Torr.

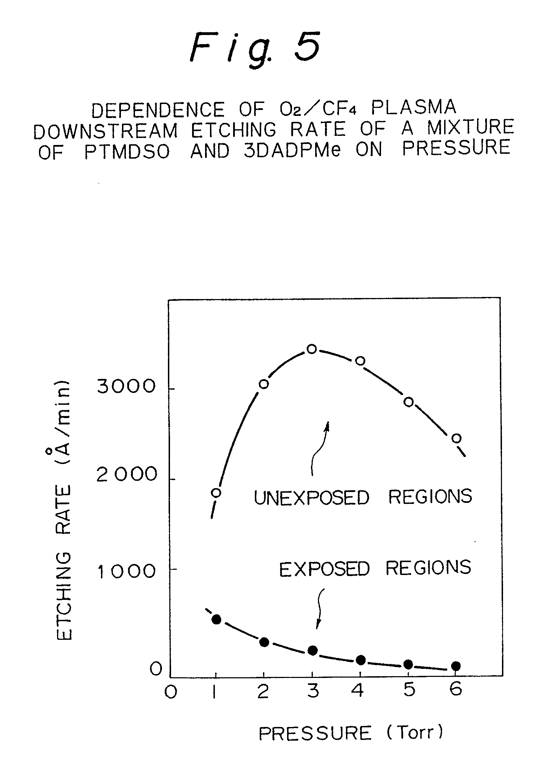

Figure 5 shows the dependence of the $O_2/CF_4$ plasma downstream etching rate of a mixture of PTMDSO and 3DADPMe on pressure. In the exposed region, the etching rate becomes lower as the pressure becomes higher. It can be easily understood that the monotonous increase of the remaining thickness shown in Fig. 4 is mainly due to a lowering of the etching rate of the exposed region.

## Claims

1. A pattern forming resist material characterized by comprising a mixture of either poly 4,4,6,6-tetramethyl-4,6-disila-2-heptyne or poly 4,4,7,7-tetramethyl-4,7-disila-2-octyne as a host polymer, and an additional reagent having at least a radical reactive on the double bond of said host polymer.
2. A pattern forming resist material according to claim 1, characterized in that said additional reagent is a diazide aromatic compound.

3. A pattern forming resist material according to claim 2, characterized in that said diazide aromatic compound is selected from the group consisting of 3,3′-diazide diphenyl methane, 4,4′-diazide diphenyl methane, 4,4,′-diazide diphenyl ethane, and 4,4′-diazide diphenyl ether.

4. A patterning process for formation of resist patterns characterized by comprising the steps of:
coating a resist material onto a substrate to form a resist layer, said resist material comprising a mixture of either poly 4,4,6,6-tetramethyl-4,6-disila-2-heptyne or poly 4,4,7,7-tetramethyl-4,7-disila-2-octyne as a host polymer and an additional reagent having at least a radical reactive on the double bonds of said host polymer;
exposing said resist layer by patterning radiation; and
developing said resist layer, to thereby remove unexposed areas of said resist layer on the substrate.

5. A process for formation of resist patterns according to claim 4, characterized in that said reactive additional reagent is a diazide aromatic compound.

6. A process for formation of resist patterns according to claim 5, characterized in that said diazide aromatic compound is selected from the group consisting of 3,3′-diazide diphenyl methane, 4,4′-diazide diphenyl methane, 4,4′-diazide diphenyl ethane and 4,4′-diazide diphenyl ether.

7. A process for formation of resist patterns according to claims 4 to 6, characterized in that said resist layer is formed on a bottom resist layer as a top patterning resist of a bilayer system.

8. A process for formation of resist patterns according to claims 4 to 7, characterized in that said patterning radiation is an ultraviolet beam and then said resist is baked in a vacuum, to thereby remove unreacted additional reagent.

9. A process for formation of resist patterns according to claims 4 to 8, characterized in that said exposed resist is developed by a downstream of a plasma containing a mixture of oxygen and a carbon fluoride or a mixture of oxygen and a hydrocarbon fluoride.

10. A process for formation of resist patterns according to claim 7, characterized in that said bottom resist layer is patterned by anisotropic dry etching using said developed top patterning resist as a mask.

11. A process for formation of resist patterns according to claim 10, characterized in that said anisotropic etching is effected by reactive ion etching or electron cyclotron resonance plasma etching.

*Fig. 1*

SCHEMATIC DIAGRAM OF
EXPERIMENTAL PROCEDURE

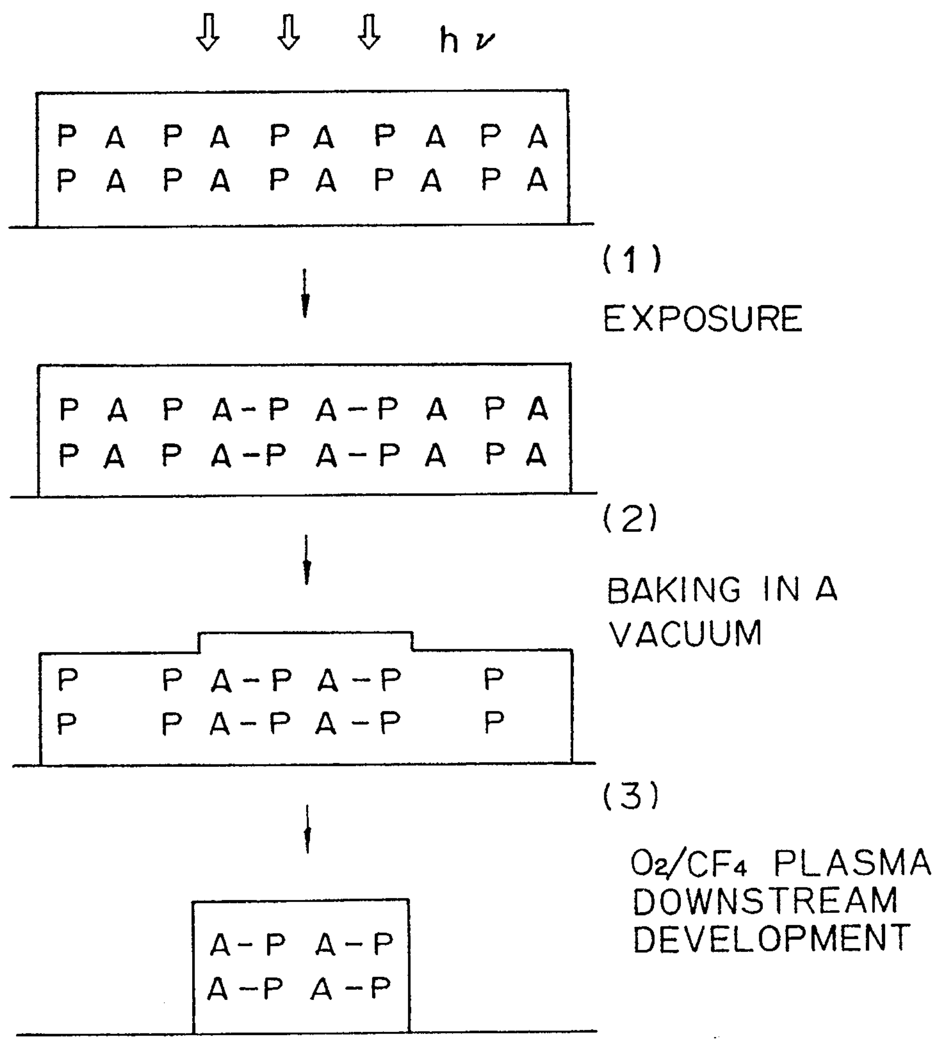

*Fig. 2*

DOWNSTREAM DEVELOPMENT APPARATUS

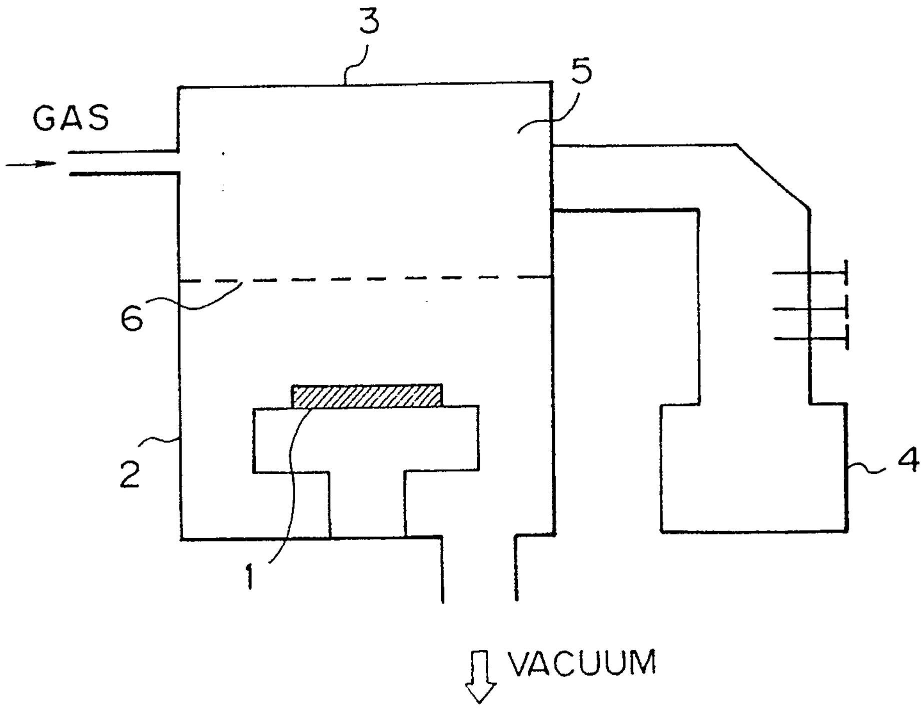

*Fig. 3*

DEPENDENCE OF REMAINING THICKNESS ON EXPOSURE ENERGY DENSITY

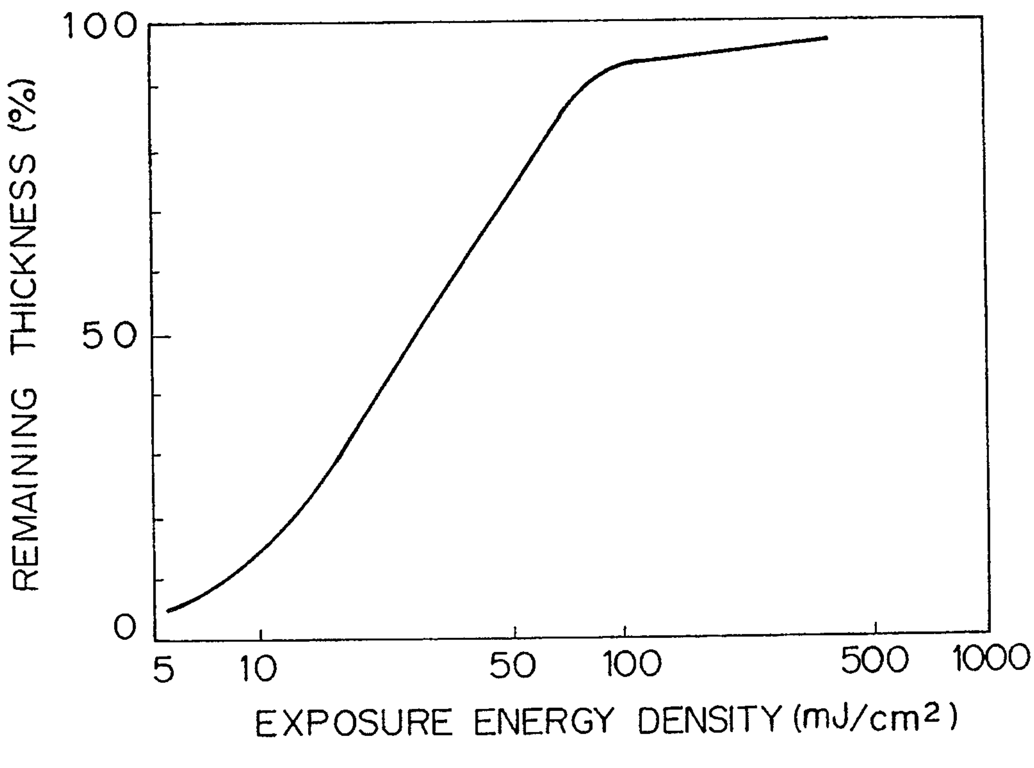

*Fig. 4*

DEPENDENCE OF REMAINING THICKNESS OF A MIXTURE OF PTMDSO AND 3DADDMe ON PRESSURE

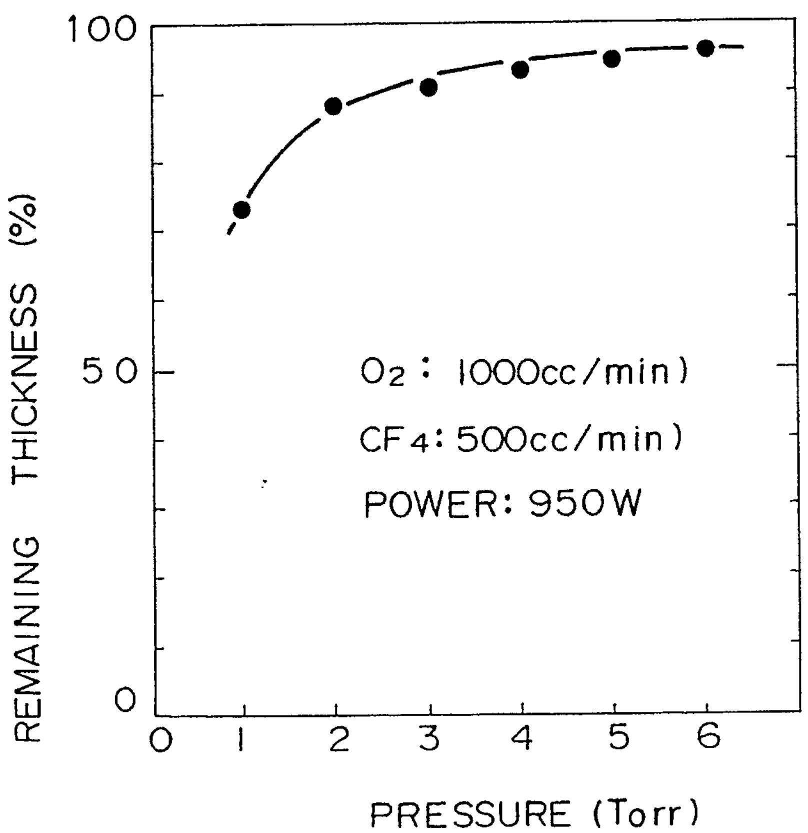

*Fig. 5*

DEPENDENCE OF $O_2/CF_4$ PLASMA DOWNSTREAM ETCHING RATE OF A MIXTURE OF PTMDSO AND 3DADPMe ON PRESSURE